(19) Europäisches Patentamt / European Patent Office / Office européen des brevets

(11) **EP 3 816 135 A1**

(12) **EUROPEAN PATENT APPLICATION**
published in accordance with Art. 153(4) EPC

(43) Date of publication:
**05.05.2021  Bulletin 2021/18**

(51) Int Cl.:
*C04B 35/453* $^{(2006.01)}$    *C01G 9/02* $^{(2006.01)}$
*C23C 14/34* $^{(2006.01)}$

(21) Application number: **19815947.7**

(22) Date of filing: **05.06.2019**

(86) International application number:
**PCT/JP2019/022358**

(87) International publication number:
**WO 2019/235532 (12.12.2019 Gazette 2019/50)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **06.06.2018  JP 2018108845**

(71) Applicant: JFE Mineral Company, Ltd.
**Tokyo 105-0014 (JP)**

(72) Inventors:
• **NAKATA Yoshimi**
  **Tokyo 105-0014 (JP)**
• **UDAGAWA Etsurou**
  **Tokyo 105-0014 (JP)**
• **ECHIZENYA Yuko**
  **Tokyo 105-0014 (JP)**

(74) Representative: **Grünecker Patent- und Rechtsanwälte**
**PartG mbB**
**Leopoldstraße 4**
**80802 München (DE)**

(54) **ZINC OXIDE POWDER FOR PRODUCING ZINC OXIDE SINTERED BODY, ZINC OXIDE SINTERED BODY, AND METHOD OF PRODUCING THESE**

(57)    A zinc oxide powder for producing a zinc oxide sintered body is provided with which it is possible to obtain a zinc oxide sintered body that has a large sintered particle size and excellent conductivity. This zinc oxide powder for producing a zinc oxide sintered body is used for producing a zinc oxide sintered body, wherein the Ga content represented in formula (I) is greater than or equal to 30 mol ppm and less than 3 mol%. (I) $\{n_{Ga}/(n_{Zn}+n_{Ga})\} \times 100$ In formula (I), $n_{Ga}$ represents the Ga content in the zinc oxide powder, $n_{Zn}$ represents the Zn content in the zinc oxide powder, and the unit of nzn and $n_{Ga}$ is moles in both cases.

## FIG. 1

EP 3 816 135 A1

**Description**

TECHNICAL FIELD

The present invention relates to zinc oxide powder for producing a zinc oxide sintered body, a zinc oxide sintered body, and methods for producing them.

BACKGROUND ART

Conventionally, various kinds of zinc oxide powder produced by different methods have been known (see Patent Literature 1, for example).

CITATION LIST

PATENT LITERATURES

Patent Literature 1: JP 2009-269946 A

SUMMARY OF INVENTION

TECHNICAL PROBLEMS

A ceramic member is typically obtained by compacting zinc oxide powder or other powder and sintering the compacted powder.

Zinc oxide powder has characteristics such as a high vapor pressure of zinc and easy particle growth, compared to other powder of aluminum oxide, zirconium oxide and the like.

A zinc oxide sintered body obtained by sintering zinc oxide powder may be required to have, for example, a large sintered particle size and excellent electrical conductivity.

The present invention has been made in view of the foregoing and an object of the invention is to provide zinc oxide powder for producing a zinc oxide sintered body, which zinc oxide powder allows production of a zinc oxide sintered body having a large sintered particle size and excellent electrical conductivity.

Another object of the present invention is to provide a zinc oxide sintered body obtained using the zinc oxide powder for producing a zinc oxide sintered body.

Yet another object of the present invention is to provide a method for preparing the zinc oxide powder for producing a zinc oxide sintered body and a method for producing the zinc oxide sintered body.

SOLUTION TO PROBLEMS

The inventors found, though an earnest study, that employing the constitutions described below enables the achievement of the above-mentioned objects.

Specifically, the present invention provides the following [1] to [8].

[1] Zinc oxide powder for producing a zinc oxide sintered body, wherein the zinc oxide powder is used to produce a zinc oxide sintered body and has a Ga content of not less than 30 mol ppm and less than 3 mol%, the Ga content being expressed by Formula (I) below:

$$\{ n_{Ga} / (n_{Zn} + n_{Ga}) \} \times 100 \ \ldots \ (I)$$

where, $n_{Ga}$ represents an amount of substance of Ga in the zinc oxide powder, $n_{Zn}$ represents an amount of substance of Zn in the zinc oxide powder, and a unit for both $n_{Zn}$ and $n_{Ga}$ is mole.

[2] The zinc oxide powder for producing a zinc oxide sintered body according to [1], wherein the zinc oxide powder is obtained by subjecting basic zinc carbonate containing gallium to heat treatment at a temperature of not lower than 250°C, the basic zinc carbonate being generated by a precipitate forming reaction of a gallium salt with a zinc salt, a carbonate and alkali and being carbonate hydrate.

[3] The zinc oxide powder for producing a zinc oxide sintered body according to [2], wherein the carbonate hydrate contains basic zinc carbonate expressed by Formula (1) below:

$$M_{4-6}(CO_3)_{1-3}(OH)_{6-7} \cdot nH_2O \ldots \qquad (1)$$

where, M represents $Zn_{1-x}Ga_x$, x represents a number of $3 \times 10^{-5}$ to 0.03, and n represents a number of 0 to 2.

[4] The zinc oxide powder for producing a zinc oxide sintered body according to any one of [1] to [3], wherein a crystallite size determined by X-ray diffraction is 20 to 100 nm, a particle size determined by BET method is 20 to 150 nm, an untamped density is not less than 0.40 $g/cm^3$, and a tap density is not less than 0.80 $g/cm^3$.

[5] A zinc oxide sintered body, wherein the zinc oxide sintered body is formed by sintering the zinc oxide powder for producing a zinc oxide sintered body according to any one of [1] to [4].

[6] A method for preparing zinc oxide powder for producing a zinc oxide sintered body, the method comprising: subjecting basic zinc carbonate containing gallium to heat treatment at a temperature of not lower than 250°C, the basic zinc carbonate being generated by a precipitate forming reaction of a gallium salt with a zinc salt, a carbonate and alkali and being carbonate hydrate, whereby the zinc oxide powder for producing a zinc oxide sintered body according to [1] is obtained.

[7] The method for preparing zinc oxide powder for producing a zinc oxide sintered body according to [6], wherein the carbonate hydrate contains basic zinc carbonate expressed by Formula (1) below:

$$M_{4-6}(CO_3)_{1-3}(OH)_{6-7} \cdot nH_2O \ldots \qquad (1)$$

where, M represents $Zn_{1-x}Ga_x$, x represents a number of $3 \times 10^{-5}$ to 0.03, and n represents a number of 0 to 2.

[8] A method for producing a zinc oxide sintered body, the method comprising: firing the zinc oxide powder for producing a zinc oxide sintered body according to any one of [1] to [4] or the zinc oxide powder for producing a zinc oxide sintered body obtained by the method according to [6] or [7], thereby obtaining a zinc oxide sintered body formed by sintering the zinc oxide powder for producing a zinc oxide sintered body.

ADVANTAGEOUS EFFECTS OF INVENTION

According to the present invention, it is possible to provide zinc oxide powder for producing a zinc oxide sintered body, which zinc oxide powder allows production of a zinc oxide sintered body having a large sintered particle size and excellent electrical conductivity.

According to the present invention, it is also possible to provide a zinc oxide sintered body obtained using the zinc oxide powder for producing a zinc oxide sintered body.

In addition, according to the present invention, it is also possible to provide a method for preparing the zinc oxide powder for producing a zinc oxide sintered body and a method for producing the zinc oxide sintered body.

BRIEF DESCRIPTION OF DRAWINGS

[FIG. 1] FIG. 1 is an SEM image showing zinc oxide powder of Synthesis Example 1.
[FIG. 2] FIG. 2 is an SEM image showing zinc oxide powder of Synthesis Example 3.
[FIG. 3] FIG. 3 is a graph showing a relationship between a crystallite size and a tap density of zinc oxide powder for each of Synthesis Example 1 and Synthesis Example 3.

DESCRIPTION OF EMBODIMENTS

[Zinc oxide powder]

Zinc oxide powder for producing a zinc oxide sintered body according to the present invention (hereinafter, also simply referred to as "zinc oxide powder of the invention") is zinc oxide powder which is used to produce a zinc oxide sintered body and which has a Ga content of not less than 30 mol ppm and less than 3 mol%, the Ga content being expressed by Formula (I) below:

$$\{n_{Ga}/(n_{Zn} + n_{Ga})\} \times 100 \ldots (I)$$

In Formula (I), $n_{Ga}$ represents an amount of substance of Ga in the zinc oxide powder, $n_{Zn}$ represents an amount of substance of Zn in the zinc oxide powder, and a unit for both $n_{Zn}$ and $n_{Ga}$ is mole.

The zinc oxide powder of the invention contains a specific amount of Ga as a trace component.

A zinc oxide sintered body obtained using the zinc oxide powder of the invention as above has a large sintered particle size and excellent electrical conductivity.

More specifically, in the case where the Ga content is not less than 30 mol ppm, the sintered particle size is larger than the case where the Ga content is less than 30 mol ppm (see Evaluation 1 described later).

In addition, in the case where the Ga content is less than 3 mol%, a value of volume resistivity or the like is small, and excellent electrical conductivity is exhibited, compared to the case where the Ga content is not less than 3 mol% (see Evaluation 1 described later).

Moreover, the zinc oxide sintered body obtained using the zinc oxide powder of the invention has a smaller variation in the sintered particle size (see Evaluation 1 described later).

The Ga content is preferably not less than 300 mol ppm and not more than 3,000 mol ppm because the sintered particle size becomes larger.

A value of the Ga content intends the same value as a Ga content expressed in terms of atom %.

With a Ga content of not less than 30 mol ppm, the obtained zinc oxide sintered body clearly exhibits a blue-green color due to solid solution of Ga. The zinc oxide sintered body (hereinafter, also simply referred to as "sintered body") is in a color of from white to pale yellow, or in a color of pale brownish green.

In the meantime, a Ga content of less than 3 mol% (less than 30,000 mol ppm) can lead to effects of, for example, no formation of $ZnGa_2O_4$ having a spinel structure, or an oxide being $Ga_2O_3$, and no formation of basic zinc carbonate gallium hydrate which is a heterogeneous phase in the precursor.

The zinc oxide powder of the invention preferably has a crystallite size determined by the X-ray diffraction (hereinafter, also simply referred to as "crystallite size") of 20 to 100 nm, a particle size determined by the BET method (hereinafter, also simply referred to as "BET diameter") of 20 to 150 nm, an untamped density (hereinafter, also simply referred to as "bulk density") of not less than 0.40 $g/cm^3$, and a tap density of not less than 0.80 $g/cm^3$.

The upper limit of the untamped density is preferably not more than 0.80 $g/cm^3$.

The tap density is more preferably not less than 1.00 $g/cm^3$, and further more preferably not less than 1.20 $g/cm^3$. The upper limit of the tap density is preferably not more than 1.60 $g/cm^3$.

The untamped density is obtained using the method according to JIS R 9301-2-3. That is, into a 100 mL-volume container standing still, zinc oxide powder is allowed to freely fall, and a mass of the collected zinc oxide powder is determined. The mass divided by the volume of the container is regarded as the untamped density.

The tap density is determined as described below. First, zinc oxide powder is put in the same container as above, and the container is tapped using a tapping device until the volume of the zinc oxide powder no longer decreases. The mass of the zinc oxide powder is divided by the volume of the zinc oxide powder after tapping, and the obtained value is regarded as the tap density.

<Preparation method of zinc oxide powder>

The method for preparing the zinc oxide powder of the present invention is not particularly limited, and a preferred example thereof is a method involving subjecting basic zinc carbonate containing gallium to heat treatment at a temperature of not lower than 250°C, the basic zinc carbonate being generated by a precipitate forming reaction of a gallium salt with a zinc salt, a carbonate and alkali and being carbonate hydrate, whereby the zinc oxide powder of the present invention is obtained (hereinafter, also referred to as "powder preparation method of the invention" for convenience).

The zinc oxide powder obtained by the powder preparation method of the invention is excellent in electrical conductivity, compared to zinc oxide powder obtained by another method, given that the Ga content is the same. It is presumed that because, for example, the zinc oxide powder undergoes the state of basic zinc carbonate (precursor) containing Ga, the zinc oxide powder uniformly includes Ga within its particles, whereby the foregoing effects can be obtained.

Meanwhile, each particle of the zinc oxide powder is so fine that it is practically impossible to observe the state of Ga and directly identify Ga contained in the particle.

In addition, it would require so many repetitions of experimentation to identify other structures or properties derived from the state of Ga, which is thus too far from realization.

In the powder preparation method of the invention, it is preferable that a gallium salt, a zinc salt, a carbonate and alkali are all used in the form of aqueous solution.

In the precipitate forming reaction, specifically, an aqueous solution of a zinc salt and an aqueous solution of a gallium salt (preferably a mixed aqueous solution of a zinc salt and a gallium salt), for example, are added dropwise to an aqueous solution of a carbonate. During the dropwise addition, the pH of the aqueous solution of a carbonate is preferably kept at a constant value (for example, a value between pH 6 and 8) with an aqueous solution of alkali being supplied.

Through the precipitate forming reaction, the carbonate hydrate (basic zinc carbonate) is obtained in the form of a precipitate. The precipitate is preferably stirred and cured.

The stirring and curing time is preferably at least 1 hour, more preferably at least 5 hours, even more preferably at least 10 hours, and particularly preferably at least 15 hours. When the stirring and curing time is long, the obtained zinc oxide powder has a high untamped density and a high tap density, compared to the case where the stirring and curing time is short, given that the Ga content is the same (see Evaluation 2 described later). In addition, the use of the obtained zinc oxide powder leads to high density of the green compact and the sintered body (see Evaluation 3 and Evaluation 4 described later).

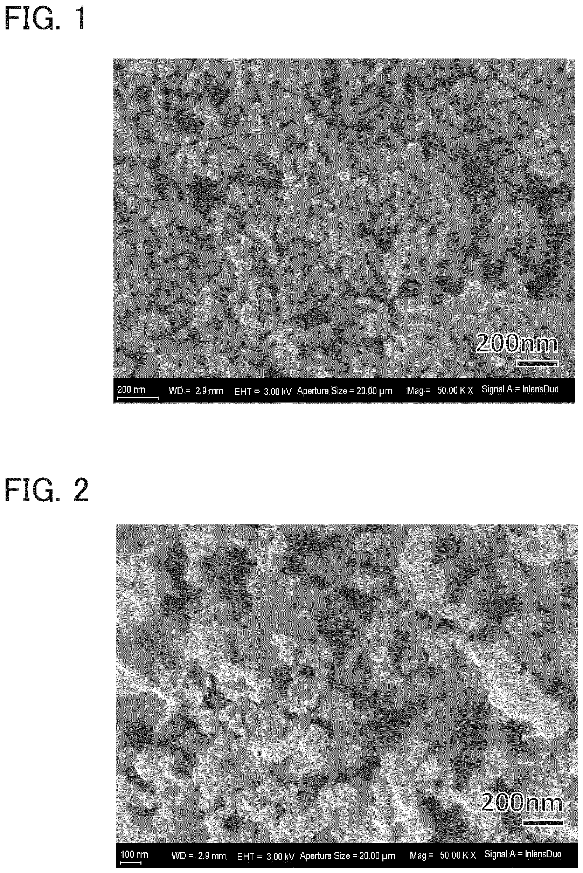

When the stirring and curing time is short, the primary particles are probably likely to bond together into a flake shape which is a characteristic shape of a layered hydroxide (see FIG. 2 described later). With a long stirring and curing time, on the contrary, the primary particles probably repeatedly collide each other due to the stirring to eliminate the flake shape, and are likely formed into a granular shape (see FIG. 1 described later).

While the stirring and curing time depends on the concentration of the solution, the stirring force or another factor, the upper limit thereof is not particularly limited, and the stirring and curing time is, for instance, not longer than 32 hours and preferably not longer than 24 hours.

During the precipitate forming reaction and the stirring and curing process, the aqueous solution of a carbonate is kept at a temperature of preferably lower than 45°C and more preferably not higher than 25°C.

A gallium salt is not particularly limited, and preferred examples thereof include gallium nitrate, gallium chloride, gallium sulphate, and hydrates thereof.

A zinc salt is not particularly limited, and preferred examples thereof include zinc nitrate, zinc sulphate, zinc chloride, zinc acetate, and hydrates thereof.

Alkali is not particularly limited, and preferred examples thereof include sodium hydroxide and potassium hydroxide. When the alkali is in the form of aqueous solution, it may be aqueous ammonia.

Examples of a carbonate include ammonium carbonate, sodium carbonate and sodium hydrogen carbonate (sodium bicarbonate), and among these, ammonium carbonate is preferred because the obtained zinc oxide powder has a high untamped density and a high tap density.

The carbonate hydrate generated by the precipitation forming reaction is preferably basic zinc carbonate containing gallium and is more preferably basic zinc carbonate expressed by Formula (1) below:

$$M_{4\text{-}6}(CO_3)_{1\text{-}3}(OH)_{6\text{-}7} \cdot nH_2O \, ... \qquad (1)$$

where, M represents $Zn_{1\text{-}x}Ga_x$, x represents a number of $3 \times 10^{-5}$ to 0.03, and n represents a number of 0 to 2.

The basic zinc carbonate expressed by Formula (1) above can be regarded as basic zinc carbonate in which part of zinc in hydrozincite ($Zn_5(CO_3)_2(OH)_6 \cdot {}_2H_2O$) is substituted with gallium, and gallium is evenly added in the molecular level. For convenience, this basic zinc carbonate may be called hydrozincite hereinbelow.

The carbonate hydrate (basic zinc carbonate) generated by the precipitate forming reaction preferably comprises the foregoing hydrozincite as the main component. The term "main component" refers to a component contained in the largest amount in the constituting substances, and the amount thereof is preferably not less than 50 mass% and more preferably not less than 60 mass%.

The carbonate hydrate (basic zinc carbonate) obtained by the precipitate forming reaction is subjected to heat treatment at a temperature of not lower than 250°C to be thereby decarboxylated and dehydrated, and zinc oxide powder is obtained.

When the heat treatment temperature is too low, decarboxylation and dehydration may excessively occur during the firing process in the production of the zinc oxide sintered body to be described later to thereby hinder the sintering.

When the heat treatment temperature is too high, on the other hand, bonded particles in which the primary particles are bonded together may increase. A large bonded particle undergoes a rapid particle growth and becomes the larger sintered particle. This phenomenon is known as Ostwald ripening and may cause nonuniform particle size of the sintered body.

In view of the foregoing, the heat treatment temperature is preferably 350°C to 420°C. When the heat treatment temperature becomes high, the necking of the primary particles leads to formation of dense secondary particles, and a high untamped density and a high tap density can be achieved.

The powder preparation method of the invention has been described above as a preferred embodiment of the method for preparing the zinc oxide powder of the present invention.

However, the method for preparing the zinc oxide powder of the present invention is not limited to the above-described powder preparation method of the invention. For instance, any powder that has been prepared by another method and has undergone pulverization, classification, particle size distribution adjustment or the like, as necessary, is construed as the zinc oxide powder of the present invention as long as it is within the scope of the present invention.

Examples of "another method" include a method involving subjecting basic zinc carbonate free of gallium to heat treatment to obtain zinc oxide powder, the basic zinc carbonate being generated through a precipitate forming reaction between a zinc salt, a carbonate and alkali, and then adding Ga in the form of, for example, an aqueous solution of a gallium salt to the zinc oxide powder, whereby zinc oxide powder containing Ga is obtained.

[Zinc oxide sintered body]

The zinc oxide sintered body of the present invention is a zinc oxide sintered body, in which the foregoing zinc oxide powder of the present invention is sintered. Hence, the zinc oxide sintered body of the present invention contains Ga. Ga is preferably in the form of solid solution.

The zinc oxide sintered body of the present invention is obtained by firing the zinc oxide powder of the present invention as described above. More specifically, for example, the zinc oxide powder of the present invention as described above is used as it is, or alternatively pulverized with a bead mill or granulated using a spray dryer, and subsequently compacted, and the obtained green compact is fired. The zinc oxide sintered body of the present invention is obtained in this manner.

The firing temperature is, for example, not lower than 800°C and not higher than 1,300°C.

The firing temperature is preferably not lower than 900°C and more preferably not lower than 1,000°C. Furthermore, the firing temperature is preferably not higher than 1,200°C, more preferably not higher than 1,150°C and further more preferably not higher than 1,100°C.

The zinc oxide sintered body of the present invention is used as a member made of ceramics, and specific examples of suitable use thereof include a plate-like bulk material; a thick-film fired product; a sputter target which requires high density and uniform particle size; and a porous member such as a gas sensor or a filter (e.g., an antibacterial filter for preventing growth of E. coli or the like).

EXAMPLES

The present invention is specifically described below with reference to examples. However, the present invention is not limited thereto.

<Synthesis Example 1 (Example 1 and Comparative Example 1)> (Synthesis)

Zinc nitrate hexahydrate (produced by Kishida Chemical Co., Ltd.) as a zinc salt, gallium nitrate octahydrate (produced by Kishida Chemical Co., Ltd.) as a gallium salt, ammonium carbonate (produced by Kishida Chemical Co., Ltd.) as a carbonate and 30 mass% sodium hydroxide (produced by Kishida Chemical Co., Ltd.) as alkali were used.

Zinc nitrate and gallium nitrate that were weighed to have a total amount of 0.5 mol were dissolved into 1L of pure water, whereby a mixed aqueous solution of zinc nitrate and gallium nitrate was prepared.

In a 2L beaker, 0.5L of 0.4M aqueous ammonium carbonate solution was prepared.

A pH electrode for pH control was provided in the aqueous ammonium carbonate solution. The mixed aqueous solution of zinc nitrate and gallium nitrate was added dropwise at a rate of 1L/h into the aqueous ammonium carbonate solution being stirred with a rotor that was set to a rotation speed of 700 rpm.

In order to prevent a decrease in pH of the aqueous ammonium carbonate solution owing to the dropwise addition of the acidic mixed aqueous solution of zinc nitrate and gallium nitrate, a pH controller (TDP-51, manufactured by Toko Kagaku Kenkyusho KK) was used to regulate the on/off switching of a liquid feeding pump, and 30 mass% sodium hydroxide was added dropwise to the aqueous ammonium carbonate solution by use of the liquid feeding pump. Accordingly, the pH of the aqueous ammonium carbonate solution was kept at a constant value of pH 7.5 during the dropwise addition of the mixed aqueous solution of zinc nitrate and gallium nitrate. A precipitate was generated through the precipitate forming reaction in this manner.

After generation of the precipitate through the precipitate forming reaction was completed, the precipitate was subjected to the stirring and curing for 20 hours by means of a rotor whose rotation speed was set to 700 rpm similarly to that during the precipitate forming reaction, whereby a slurry of basic zinc carbonate containing gallium was obtained.

During the precipitate forming reaction and the stirring and curing, a cooling device was used such that the aqueous ammonium carbonate solution constantly had a temperature lower than 30°C.

The slurry having been subjected to the stirring and curing was separated into solid and liquid components by the suction filtration method, and a solid component was obtained. The obtained solid component was washed to remove undesired sodium or the like. Specifically, the solid component was again converted into a slurry using an appropriate amount of pure water, and the slurry thus obtained was separated into solid and liquid components by the suction filtration method. This washing process was repeated four times.

The washed solid component was dried in vacuum at 30°C for 20 hours using a vacuum dryer. Thus, dried powder of basic zinc carbonate containing gallium that is a precursor of zinc oxide powder was obtained.

In Synthesis Example 1 (Example 1 and Comparative Example 1), the synthesis was carried out such that the molar ratio of gallium to zinc (Ga/Zn) fell within the range of 0/100 to 10/90.

More specifically, the Ga content expressed by Formula (I) described above was set to 30 mol ppm, 300 mol ppm and 3,000 mol ppm (0.3 mol%) in Example 1 and 0 mol ppm, 10 mol ppm, 30,000 mol ppm (3 mol%), 50,000 mol ppm (5 mol%) and 100,000 mol ppm (10 mol%) in Comparative Example 1.

In the case where the Ga content was 0 mol ppm, an aqueous zinc nitrate solution was prepared without using gallium nitrate octahydrate and was added dropwise to an aqueous ammonium carbonate solution.

Of the obtained basic zinc carbonate, the mineral phase was identified by an X-ray diffractometer (D8ADVANCE, manufactured by BRUKER CORPORATION), and the crystallite size was measured according to the Scherrer method.

In addition, the thermal reduction was measured with a TG-DTA device (TG/DTA6300, manufactured by Hitachi High-Tech Corporation), the carbon analysis was carried out by the combustion method using an analyzer (LECO CS844), and Zn and Na were analyzed using an ICP emission spectrometer (ICP-9000, manufactured by Shimadzu Corporation).

Based on the results of the X-ray diffraction and the component analyses, it was confirmed that the basic zinc carbonate containing hydrozincite as a main component was obtained.

In Comparative Example 1 where the Ga content was 10 mol%, a heterogeneous phase identified as zinc gallium carbonate hydroxide hydrate was dominant.

Meanwhile, when the filtrate was analyzed, it was found that the precipitate had a yield of 99%. In addition, it was also found that the thermal reduction due to decarboxylation and dehydration would terminate at a temperature of about 600°C.

(Heat Treatment)

The basic zinc carbonate thus obtained was put in an alumina crucible and subjected to heat treatment at 380°C in an air atmosphere for decarboxylation and dehydration. The temperature increase rate was 2°C/min., the retaining time at 380°C was 6 hours, and the cooling step was natural cooling. Zinc oxide powder was obtained in this manner.

In the case where the Ga content was not less than 3 mol%, a heterogeneous phase in which gallium oxide and zinc-gallium spinel were identified was dominant.

As described above, the heat treatment temperature is not lower than 250°C, preferably 350°C to 420°C, and is appropriately selected depending on the desired properties of the zinc oxide sintered body. The influence of the heat treatment temperature on the tap density and the like was studied, and the result thereof will be described later.

(Production of green compact)

The obtained zinc oxide powder was sieved with a 0.6 mm sieve for a simple pulverization and press-formed under a pressure of 60 MPa, whereby a disc-like green compact of φ20 mm x 2 mm and a plate-like green compact of 40 x 40 x 5 mm were produced. Green compacts of each shape were produced to satisfy n=15.

At this time, with an expectation to clarify the influence on the green compact and the sintered body from the zinc oxide powder's property difference depending on the synthesis condition, granulation using a spray-dryer, or the like, was not carried out. In the meantime, this is not always the case in production of an actual product.

As described later, the disc-like green compact was used as a sample for the Scanning Electron Microscope (SEM) observation, the density measurement, and the X-ray diffraction, while the plate-like green compact was used as a sample for the electrical resistance measurement.

(Production of sintered body)

The disc-like green compact and the plate-like green compact thus produced were fired in an air atmosphere. The firing temperature was 900 to 1,200°C (at 100°C intervals), the retaining time at the firing temperature was 6 hours, the temperature increase rate was 4°C/min., and the cooling step was carried out by leaving the body to stand in a furnace. A disc-like sintered body and a plate-like sintered body were obtained in this manner.

<Evaluation 1>

Using the obtained sintered bodies, various evaluations were conducted.

The disc-like sintered body was observed using an SEM, and the sintered particle size (unit: μm) was measured.

In addition, the plate-like sintered body was formed into a rod shape of 30 mm x 4 mm x 4 mm, and thereafter the volume resistivity (unit: Q • cm) was measured by the four-terminal method.

The sintered particle size and the volume resistivity were each an average value of 15 samples. Concerning the sintered particle size, the standard deviation and the variation coefficient (= (standard deviation/average value) x 100) were also determined. The variation coefficient (unit: %) serves as an index of variation. The results thereof are shown in Tables 1 and 2 below.

[Table 1]

Table 1

| Firing temperature [°C] | Sintered body properties | Comparative Example 1 | | Example 1 | | | Comparative Example 1 | | |
|---|---|---|---|---|---|---|---|---|---|
| | | 1-1 | 1-2 | 1-1 | 1-2 | 1-3 | 1-3 | 1-4 | 1-5 |
| | | Ga content [mol ppm] | | | | | | | |
| | | 0 | 10 | 30 | 300 | 3000 | 30000 | 50000 | 100000 |
| 1000 | Sintered particle size [$\mu$m] | 2.7 | 2.8 | 2.9 | 3.2 | 3.4 | - | - | - |
| | Standard deviation | 0.852 | 0.831 | 0.843 | 0.513 | 0.591 | - | - | - |
| | Variation coefficient [%] | 31.56 | 29.68 | 29.07 | 16.03 | 17.38 | - | - | - |
| 1100 | Sintered particle size [$\mu$m] | 3.7 | 3.9 | 4.7 | 5.8 | 6.1 | - | - | - |
| | Standard deviation | 0.890 | 1.032 | 1.553 | 0.425 | 0.814 | - | - | - |
| | Variation coefficient [%] | 24.14 | 26.46 | 32.81 | 7.39 | 13.28 | - | - | - |
| 1200 | Sintered particle size [$\mu$m] | 6.0 | 6.2 | 6.5 | 7.0 | 9.2 | - | - | - |
| | Standard deviation | 1.542 | 1.739 | 2.093 | 1.357 | 1.616 | - | - | - |
| | Variation coefficient [%] | 25.70 | 28.05 | 31.99 | 19.45 | 17.56 | - | - | - |

As Table 1 above shows, in Example 1-1 to Example 1-3 where the Ga content was not less than 30 mol ppm and less than 30,000 mol ppm (less than 3 mol%), the sintered particle size was large at any firing temperature, compared to Comparative Example 1-1 to Comparative Example 1-2 where the Ga content was less than 30 mol ppm. In this regard, the sintered particle size tended to become larger as the firing temperature was higher.

In Comparative Example 1-3 to Comparative Example 1-5 where the Ga content was not less than 30,000 mol ppm (not less than 3 mol%), since a heterogeneous phase different from zinc oxide was dominant, it was impossible to measure the sintered particle size. Accordingly, the corresponding spaces in Table 1 above were filled with "-."

In addition, compared to Comparative Example 1-1 to Comparative Example 1-2, Example 1-1 to Example 1-3 were likely to have a small value of the variation coefficient, tending to have a small variation in the sintered particle size.

[Table 2]

Talbe 2

| Firing temperature [°C] | Sintered body properties | Comparative Example 1 | | Example 1 | | | Comparative Example 1 | | |
|---|---|---|---|---|---|---|---|---|---|
| | | 1-1 | 1-2 | 1-1 | 1-2 | 1-3 | 1-3 | 1-4 | 1-5 |
| | | Ga content [mol ppm] | | | | | | | |
| | | 0 | 10 | 30 | 300 | 3000 | 30000 | 50000 | 100000 |
| 1100 | Volume resistivity [Ω · cm] | 65000 | 10050 | 65.2 | 0.215 | 0.27 | 3200 | 15000 | 40000 |
| 1200 | | 4000 | 810 | 50 | 0.405 | 0.3133 | 1165 | 10000 | 30000 |

In a case where the volume resistivity was not measured, the corresponding space in Table 2 above was filled with "-."

As Table 2 above shows, Example 1-1 to Example 1-3 where the Ga content was not less than 30 mol ppm and less than 30,000 mol ppm (less than 3 mol%) had small volume resistivity and exhibited excellent electrical conductivity at any firing temperature, compared to Comparative Example 1-1 to Comparative Example 1-2 where the Ga content was less than 30 mol ppm and Comparative Example 1-3 to Comparative Example 1-5 where the Ga content was not less than 30,000 mol ppm (not less than 3 mol%).

<Synthesis Example 2 (Example 2)>

The zinc oxide powder that was prepared in Synthesis Example 1 and was free of Ga (zinc oxide powder of Comparative Example 1-1) was added to and mixed with an aqueous gallium nitrate solution, and dried at 200°C, whereby zinc oxide powder having a Ga content of 300 mol ppm and zinc oxide powder having a Ga content of 3,000 mol ppm were obtained. It is presumed that in the obtained zinc oxide powder, Ga deposited as an amorphous hydroxide was fixed on the surfaces of the powder particles.

<Synthesis Example 3 (Comparative Example 3 and Example 3)>

Dried powder of basic zinc carbonate was obtained in the same manner as in Synthesis Example 1 except that the stirring and curing time following the completion of generation of the precipitate through the precipitate forming reaction was changed to 10 minutes. The same analyses as in Synthesis Example 1 were conducted, and, as a result, it was confirmed that basic zinc carbonate containing hydrozincite as a main component was obtained. Meanwhile, when the filtrate was analyzed, it was found that the precipitate had a yield of about 99%.

Using the obtained basic zinc carbonate, the same heat treatment as in Synthesis Example 1 was carried out, and zinc oxide powder was obtained. In Synthesis Example 3, the Ga content was 0 mol ppm, 300 mol ppm and 3,000 mol ppm.

<Evaluation 2: Evaluation of zinc oxide powder>

The zinc oxide powder of Synthesis Example 1 (Comparative Example 1 and Example 1) and the zinc oxide powder of Synthesis Example 3 (Comparative Example 3 and Example 3) were subjected to the X-ray diffraction using an X-ray diffractometer (D8ADVANCE, manufactured by BRUKER CORPORATION) to determine the crystallite size and, in addition, to the specific surface area measurement according to the BET method using a BET specific surface area measurement device (AUTOSORB-MP1, manufactured by Quantachrome Instruments Japan G.K.) to determine the BET diameter. In addition, the untamped density and the tap density thereof were obtained according to the foregoing method. The results are shown in Table 3 below.

[Table 3]

Table 3

| | | | Ga content [mol ppm] | Crystallite size [nm] | BET diameter [nm] | Untamped density [g/cm$^3$] | Tap density [g/cm$^3$] |
|---|---|---|---|---|---|---|---|
| Synthesis Example 1 | Comparative Example 1 | 1-1 | 0 | 80 | 88.0 | 0.82 | 1.35 |
| | Example 1 | 1-2 | 300 | 82 | 89.1 | 0.85 | 1.49 |
| | | 1-3 | 3000 | 86 | 91.3 | 0.88 | 1.51 |
| Synthesis Example 3 | Comparative Example 3 | 3-1 | 0 | 85 | 93.5 | 0.36 | 0.59 |
| | Example 3 | 3-1 | 300 | 86 | 90.8 | 0.38 | 0.64 |
| | | 3-2 | 3000 | 86 | 89.9 | 0.39 | 0.68 |

As Table 3 above shows, the zinc oxide powder of Synthesis Example 1 exhibited the higher values of untamped density and tap density than those of Synthesis Example 3. Therefore, it can be expected that, when the zinc oxide powder of Synthesis Example 1 is formed and sintered, the filling density becomes high to increase contact points among the particles, whereby the shrinkage is reduced, and a dense sintered body can be obtained at a low temperature (e.g., not higher than 1,000°C).

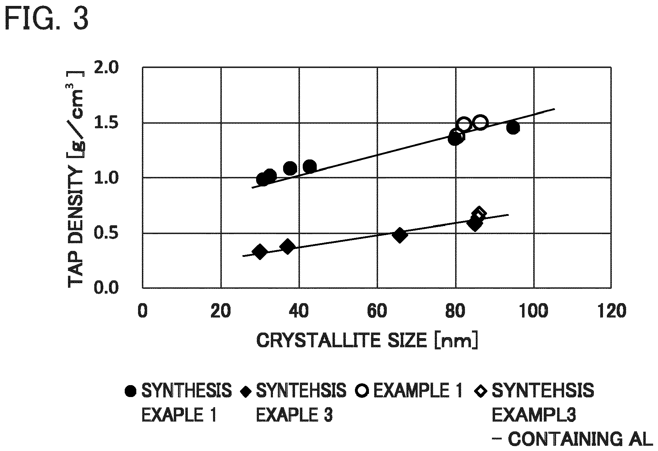

In addition, in Synthesis Example 1 and Synthesis Example 3, the temperature during heat treatment of basic zinc carbonate (heat treatment temperature) was not only 380°C but was varied in the range of 350°C to 420°C, whereby the zinc oxide powder was prepared, and the crystallite size and the tap density in each case were obtained. The results are shown in a graph of FIG. 3.

FIG. 3 is a graph showing a relationship between the crystallite size and the tap density of the zinc oxide powder for each of Synthesis Example 1 and Synthesis Example 3.

In the graph of FIG. 3, Synthesis Example 1 (Example 1) having a Ga content of 30 mol ppm to 3,000 mol ppm is plotted with outlined white circles, Synthesis Example 1 free of Ga with filled black circles, Synthesis Example 3 containing Ga with outlined white rhombuses, and Synthesis Example 3 free of Ga with filled black rhombuses. The respective plots of the synthesis examples encompass differences in the heat treatment temperature.

From the graph of FIG. 3, it is found that Synthesis Example 1 could achieve the tap density of about three times as high as that of Synthesis Example 3, given that the crystallite size is about the same.

The zinc oxide powder of Synthesis Example 1 and the zinc oxide powder of Synthesis Example 3 (both containing no Ga) were observed using an ultra-low accelerating SEM at an acceleration voltage of 3kV.

FIG. 1 is an SEM image showing the zinc oxide powder of Synthesis Example 1. FIG. 2 is an SEM image showing the zinc oxide powder of Synthesis Example 3. In Synthesis Example 1 (FIG. 1), aggregation and bonding of particles constituting the zinc oxide powder are less than those in Synthesis Example 3 (FIG. 2), and an excessive particle growth is apparently suppressed.

More specifically, it is presumed that in Synthesis Example 3, the shorter stirring and curing time caused the primary particles to bond together into a flake shape. On the contrary, in Synthesis Example 1, since the stirring and curing time was long, the primary particles probably repeatedly collided each other due to the stirring to thereby eliminate the flake shape, and were formed into a granular shape.

Although the reason for the higher tamp density of the zinc oxide powder of Synthesis Example 1 than that of Synthesis Example 3 (see FIG. 3) is not clear, it may be because, for example, aggregation and bonding of particles constituting the zinc oxide powder are insignificant (see FIG. 1); and the secondary particles are formed through appropriate aggregation.

<Evaluation 3: Evaluation of green compact>

The zinc oxide powder of Synthesis Example 3 was also press-formed in the same manner as in Synthesis Example 1, and disc-like green compacts (n=15) of φ20 mm x 2 mm were obtained.

The density (unit: g/cm$^3$) of each disc-like green compact was determined.

The green compact density was an average value of 15 samples, and the standard deviation and the variation coefficient (=(standard deviation/average value) x 100) were also determined. The variation coefficient (unit: %) serves as an index of variation. The results are shown in Table 4 below.

[Table 4]

Table 4

| | | | Ga content [mol ppm] | Green compact density [g/cm$^3$] | Stan dard deviation | Variation coefficient [%] |
|---|---|---|---|---|---|---|
| Synthesis Example 1 | Comparative Example 1 | 1-1 | 0 | 2.89 | 0.0228 | 0.79 |
| | Example 1 | 1-2 | 300 | 2.52 | 0.0125 | 0.50 |
| | | 1-3 | 3000 | 2.44 | 0.0110 | 0.45 |
| Synthesis Example 3 | Comparative Example 3 | 3-1 | 0 | 2.45 | 0.0294 | 1.20 |
| | Example 3 | 3-1 | 300 | 2.31 | 0.0312 | 1.35 |
| | | 3-2 | 3000 | 2.30 | 0.0329 | 1.43 |

As Table 4 above shows, it was found that the green compacts of Example 1 had high density and small variation compared to Example 3 in the case of the same Ga content. Therefore, the zinc oxide powder of Example 1 is suitable for press-formation.

<Evaluation 4: Evaluation of sintered body>

The zinc oxide powder of Synthesis Example 3 was also press-formed and thereafter fired in the same manner as in Synthesis Example 1, and disc-like sintered bodies (n=15) were obtained.
The density (unit: g/cm$^3$) of each disc-like sintered body was determined, and the sintered particle size (unit: $\mu$m) thereof was measured using an SEM.
The sintered body density and the sintered particle size were each an average value of 15 samples. For each of these measurement items, the standard deviation and the variation coefficient (=(standard deviation/average value) x 100) were also determined. The variation coefficient (unit: %) serves as an index of variation. The results are shown in Table 5 below.

[Table 5]

Table 5

| | | | Ga content [mol ppm] | Firing temperature [°C] | | | Firing temperature [°C] | | | Firing temperature [°C] | | |
|---|---|---|---|---|---|---|---|---|---|---|---|---|
| | | | | 900 | | | 1000 | | | 1200 | | |
| | | | | Sintered body density [g/cm$^3$] | Standard deviation | Variation coefficient [%] | Sintered body density [g/cm$^3$] | Standard deviatio n | Variation coefficient [%] | Sintered body density [g/cm$^3$] | Standard deviatio n | Variation coefficient [%] |
| Synthesis Example 1 | Comparative Example 1 | 1-1 | 0 | 5.40 | 0.0486 | 0.90 | 5.45 | 0.0480 | 0.88 | 5.55 | 0.0477 | 0.86 |
| | Example 1 | 1-2 | 300 | 5.21 | 0.0457 | 0.88 | 5.58 | 0.0333 | 0.60 | 5.53 | 0.0218 | 0.39 |
| | | 1-3 | 3000 | 5.28 | 0.0169 | 0.32 | 5.49 | 0.0110 | 0.20 | 5.52 | 0.0154 | 0.28 |
| Synthesis Example 3 | Comparative Example 3 | 3-1 | 0 | 5.20 | 0.0598 | 1.15 | 5.28 | 0.0633 | 1.20 | 5.35 | 0.0653 | 1.22 |
| | Example 3 | 3-1 | 300 | 4.74 | 0.0554 | 1.17 | 4.99 | 0.0525 | 1.05 | 5.07 | 0.0855 | 1.69 |
| | | 3-2 | 3000 | 4.66 | 0.0624 | 1.34 | 4.87 | 0.0549 | 1.13 | 5.34 | 0.0784 | 1.47 |

As Table 5 above shows, it was found that each sintered body of Example 1 had high density and small variation compared to Example 3 in the case of the same Ga content.

Accordingly, and also in view of the results shown in Table 2 above, the zinc oxide powder of Example 1 is excellent in electrical conductivity, and is suitable as zinc oxide powder for producing a zinc oxide sintered body that is used to obtain a dense sintered body.

**Claims**

1. Zinc oxide powder for producing a zinc oxide sintered body, wherein the zinc oxide powder is used to produce a zinc oxide sintered body and has a Ga content of not less than 30 mol ppm and less than 3 mol%, the Ga content being expressed by Formula (I) below:

$$\{n_{Ga}/(n_{Zn} + n_{Ga})\} \times 100 \ ... \ (I)$$

where, $n_{Ga}$ represents an amount of substance of Ga in the zinc oxide powder, $n_{Zn}$ represents an amount of substance of Zn in the zinc oxide powder, and a unit for both $n_{Zn}$ and $n_{Ga}$ is mole.

2. The zinc oxide powder for producing a zinc oxide sintered body according to claim 1, wherein the zinc oxide powder is obtained by subjecting basic zinc carbonate containing gallium to heat treatment at a temperature of not lower than 250°C, the basic zinc carbonate being generated by a precipitate forming reaction of a gallium salt with a zinc salt, a carbonate and alkali and being carbonate hydrate.

3. The zinc oxide powder for producing a zinc oxide sintered body according to claim 2, wherein the carbonate hydrate contains basic zinc carbonate expressed by Formula (1) below:

$$M_{4\text{-}6}(CO_3)_{1\text{-}3}(OH)_{6\text{-}7} \cdot nH_2O \ ... \qquad (1)$$

where, M represents $Zn_{1\text{-}x}Ga_x$, x represents a number of $3 \times 10^{-5}$ to 0.03, and n represents a number of 0 to 2.

4. The zinc oxide powder for producing a zinc oxide sintered body according to any one of claims 1 to 3, wherein a crystallite size determined by X-ray diffraction is 20 to 100 nm, a particle size determined by BET method is 20 to 150 nm, an untamped density is not less than 0.40 g/cm$^3$, and a tap density is not less than 0.80 g/cm$^3$.

5. A zinc oxide sintered body, wherein the zinc oxide sintered body is formed by sintering the zinc oxide powder for producing a zinc oxide sintered body according to any one of claims 1 to 4.

6. A method for preparing zinc oxide powder for producing a zinc oxide sintered body, the method comprising: subjecting basic zinc carbonate containing gallium to heat treatment at a temperature of not lower than 250°C, the basic zinc carbonate being generated by a precipitate forming reaction of a gallium salt with a zinc salt, a carbonate and alkali and being carbonate hydrate, whereby the zinc oxide powder for producing a zinc oxide sintered body according to claim 1 is obtained.

7. The method for preparing zinc oxide powder for producing a zinc oxide sintered body according to claim 6, wherein the carbonate hydrate contains basic zinc carbonate expressed by Formula (1) below:

$$M_{4\text{-}6}(CO_3)_{1\text{-}3}(OH)_{6\text{-}7} \cdot nH_2O \ ... \qquad (1)$$

where, M represents $Zn_{1\text{-}x}Ga_x$, x represents a number of $3 \times 10^{-5}$ to 0.03, and n represents a number of 0 to 2.

8. A method for producing a zinc oxide sintered body, the method comprising: firing the zinc oxide powder for producing a zinc oxide sintered body according to any one of claims 1 to 4 or the zinc oxide powder for producing a zinc oxide sintered body obtained by the method according to claim 6 or 7, thereby obtaining a zinc oxide sintered body formed by sintering the zinc oxide powder for producing a zinc oxide sintered body.

FIG. 1

FIG. 2

FIG. 3

● SYNTHESIS ◆ SYNTEHSIS ○ EXAMPLE 1 ◇ SYNTEHSIS
EXAPLE 1    EXAPLE 3                EXAMPL3
                                        – CONTAINING AL

## INTERNATIONAL SEARCH REPORT

International application No.

PCT/JP2019/022358

### A. CLASSIFICATION OF SUBJECT MATTER

Int.Cl. C04B35/453(2006.01)i, C01G9/02(2006.01)i, C23C14/34(2006.01)i

According to International Patent Classification (IPC) or to both national classification and IPC

### B. FIELDS SEARCHED

Minimum documentation searched (classification system followed by classification symbols)

Int.Cl. C04B35/453, C01G9/02, C23C14/34

Documentation searched other than minimum documentation to the extent that such documents are included in the fields searched

| | |
|---|---|
| Published examined utility model applications of Japan | 1922–1996 |
| Published unexamined utility model applications of Japan | 1971–2019 |
| Registered utility model specifications of Japan | 1996–2019 |
| Published registered utility model applications of Japan | 1994–2019 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2013-189369 A (SUMITOMO CHEMICAL CO., LTD.) 26 September 2013, claims, paragraphs [0023]-[0024], [0088], example 3 (Family: none) | 1, 5, 8<br>4<br>2-3, 6-7 |
| Y | JP 2015-24944 A (TOSOH CORP.) 05 February 2015, claims, paragraph [0054] & TW 201410904 A | 4 |
| X<br>A | JP 2017-36244 A (JFE MINERAL CO., LTD.) 16 February 2017, claims, paragraphs [0025], [0034], example 2 (Family: none) | 1-3, 5-8<br>4 |

☐ Further documents are listed in the continuation of Box C.   ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>13 August 2019 (13.08.2019) | Date of mailing of the international search report<br>27 August 2019 (27.08.2019) |
|---|---|
| Name and mailing address of the ISA/<br>Japan Patent Office<br>3-4-3, Kasumigaseki, Chiyoda-ku,<br>Tokyo 100-8915, Japan | Authorized officer<br><br>Telephone No. |

Form PCT/ISA/210 (second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009269946 A